# EUROPEAN PATENT APPLICATION

(11) **EP 4 546 971 A1**
(43) Date of publication of application: **30.04.2025**
(21) Application number: 24208327.7
(22) Date of filing: 23.10.2024
(51) Int. Cl.: H10D 30/01, H10D 30/47, H10D 62/17, H10D 64/00, H10D 84/05, H10D 84/80

(54) **SUBSTRATE BIASING FOR A TRANSISTOR STRUCTURE THAT USES A TWO-DIMENSIONAL ELECTRON GAS**

(30) Priority: 24.10.2023 US 202318493665
(71) Applicant: Infineon Technologies Canada Inc., Kanata, Ontario K2V 1C8 (CA)
(72) Inventor: ABDALI MASHHADI, Iman, Kanata, K2V 1C8 (CA); BOZORGI, Mohammad, Kanata, K2V 1C8 (CA); UNNI, Vineet, Kanata, K2V 1C8 (CA); MACELWEE, Thomas William, Kanata, K2V 1C8 (CA); DIXIT, Abhinandan Hemant, Kanata, K2V 1C8 (CA); ZUNIGA, Marco A., Kanata, K2V 1C8 (CA)
(74) Representative: Kraus & Lederer PartGmbB

(57) **Abstract**

A transistor structure that includes a biased substrate. The transistor structure comprises a barrier semiconductor layer and a channel semiconductor layer immediately beneath the barrier semiconductor layer to form a heterojunction interface with the barrier semiconductor layer, the heterojunction inducing a two-dimensional electron gas (2DEG) within the channel semiconductor layer. A semiconductor substrate is beneath and rigidly coupled to the channel semiconductor layer and the barrier semiconductor layer. A substrate contact layer is disposed immediately beneath the semiconductor substrate. The substrate contact layer is electrically disconnected from the source contact to allow for a different voltage to be applied to the substrate contact layer as compared to the source contact. A biasing circuit is configured to bias the substrate contact layer.

## Description

### BACKGROUND

Electronic circuits typically include transistors, which are devices that function as electronic switches that regulate or control current flow in portions of the circuit. One type of transistor is a field-effect transistor in which a voltage is applied to a gate terminal to turn the transistor on and off. A semiconductor channel region is disposed between the drain terminal and the source terminal. When the transistor is on, current flows through the semiconductor channel region between the source terminal and the drain terminal. When the transistor is off, lesser or no current flows through the semiconductor channel region between the source terminal and the drain terminal. The gate terminal is disposed over the semiconductor channel region between the source terminal and the drain terminal. Voltage on the gate terminal generates a field that affects whether the semiconductor channel region conducts current - hence the term "field-effect transistor".

Silicon has traditionally been used to fabricate transistors. However, wider bandgap semiconductor material may be used to fabricate transistors that conduct higher power and operate at higher efficiency than silicon transistors. Silicon carbide (SiC), Aluminum Nitride (AlN) Zinc Oxide (ZnO), and Gallium Arsenide (GaAs) are each examples of wide bandgap semiconductor materials that can be used in power electronics. One way to use such wider bandgap semiconductor materials is to form two layers of different semiconductor materials to therebetween form a heterojunction.

These two semiconductor materials may have sufficiently different bandgaps such that when brought together, the joined bandgap drops below the Fermi level just within the channel layer. This means that electrons may freely flow within this region. This region is thin in depth and forms a plane parallel to the upper surface of the channel region. Thus, this region is called a "Two-Dimensional Electron Gas" (or "2DEG") (emphasizing "Two-Dimensional") to emphasize its planar form. Furthermore, this region is also referred to as a "Two-Dimensional Electron Gas" (emphasizing "Electron Gas") due to the high mobility of electrons in this region. Thus, the 2DEG is highly conductive. The 2DEG may form the channel region of a power semiconductor with relatively low resistance to allow passage of a large amount of current.

An important characteristic of transistors is the maximum current the transistor can allow when operating in saturation mode. This characteristic is called the saturation current (sometimes abbreviated as "Idsat"). The higher a transistor's Idsat, the more current the transistor can allow while operating in the saturation mode. This may be especially desirable in high voltage applications because a transistor's ability to transfer current at high voltages means that the transistor can more efficiently transfer power.

Transistors can experience leakage current, which is the unwanted or undesirable current that flows when the transistor is off. Over time, leakage current may cause the transistor to degrade. There are multiple potential paths for leakage current to take in a transistor. One example, known as substrate leakage or vertical leakage, occurs when current undesirably flows through the substrate of the transistor to ground. Substrate leakage may arise due to flaws in the substrate, imperfections in the material, or high electric fields that can each create unintended paths for current through the substrate.

The subject matter claimed herein is not limited to embodiments that solve any disadvantages or that operate only in environments such as those described above. Rather, this background is only provided to illustrate one exemplary technology area where some embodiments described herein may be practiced.

### BRIEF SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

A transistor structure as defined in claim 1 is provided. The dependent claims define further embodiments.

Embodiments described herein relate to a transistor structure that includes a biased substrate. For example, a transistor structure comprises a barrier semiconductor layer and a channel semiconductor layer immediately beneath the barrier semiconductor layer to form a heterojunction interface with the barrier semiconductor layer, the heterojunction inducing a two-dimensional electron gas (2DEG) within the channel semiconductor layer. A source contact and a drain contact are each in conductive contact with the 2DEG. A gate terminal is proximate to the 2DEG such that voltages applied to the gate terminal control whether the 2DEG is continuous between the source contact and the drain contact.

A semiconductor substrate is beneath and rigidly coupled to the channel semiconductor layer and the barrier semiconductor layer. For example, the channel layer and barrier semiconductor layer may be epitaxially grown on layers supported by the semiconductor substrate. A substrate contact layer is disposed immediately beneath the semiconductor substrate. The substrate contact layer is electrically disconnected or disconnectable from the source contact to allow for a different voltage to be applied to the substrate contact layer as compared to the source contact. The transistor structure also includes a biasing circuit that is configured to bias the substrate contact layer. Thus, the substrate may be biased to a different voltage than the source terminal.

In other words, the transistor structure embodies a four terminal transistor, the terminals being 1) the source contact, 2) the drain contact, 3) the gate terminal, and 4) the substrate. This contrast with a three terminal device that includes just the source contact, the drain contact, and the gate terminal. In the previous transistor structure, the substrate was shorted to the source contact, and thus the substrate cannot be considered another terminal. Using the substrate as a fourth terminal provides for numerous potential advantages.

For instance, by biasing the substrate, the vertical electrical field encountered by the transistor structure may be adjusted. As an example, by weakening the vertical electrical field, the motive power driving vertical leakage is reduced, thus reducing vertical leakage itself, which prevents harm to the transistor structure, conserves power, and extends the life of the transistor structure. Alternatively, or in addition, the reduced vertical electrical field allows the thickness of the transistor structure to be reduced, and/or allows the voltage applied to the drain to be increased.

Furthermore, controlling the substrate bias allows for controlling the 2DEG charge. For example, by increasing the 2DEG charge, the saturation current of the transistor structure may be increased, allowing more power to be transferred. Alternatively, or in addition, this improved saturation current may allow the transistor to be smaller in footprint. A reduced transistor footprint means that more transistors can be fabricated on a single wafer. Furthermore, since the area of the transistor is reduced, the opportunity for manufacturing defects is reduced, and yield may potentially be increased. That is, there is the potential to reduce the percentage of unusable or defective transistors present on a wafer. Furthermore, controlling the substrate bias improves both the dynamic and static on-resistance of the transistor.

Additional features and advantages will be set forth in the description which follows, and in part will be obvious from the description, or may be learned by the practice of the teachings herein. Features and advantages of the invention may be realized and obtained by means of the instruments and combinations particularly pointed out in the appended claims. Features of the present invention will become more fully apparent from the following description and appended claims or may be learned by the practice of the invention as set forth hereinafter.

### BRIEF DESCRIPTION OF THE DRAWINGS

In order to describe the manner in which the above-recited and other advantages and features can be obtained, a more particular description of the subject matter briefly described above will be rendered by reference to specific embodiments which are illustrated in the appended drawings. Understanding that these drawings depict only typical embodiments and are not therefore to be considered to be limiting in scope, embodiments will be described and explained with additional specificity and detail through the use of the accompanying drawings in which:
Figure 1 is an illustration of an embodiment of a transistor structure in accordance with the principles described herein.
Figure 2 illustrates a transistor structure that is a specific example of the transistor structure of Figure 1.
Figures 3A, 3B and 3C each illustrate biasing environments in which a high voltage V_{H} is generated from a drain of a power transistor, where that high voltage V_{H} may then be used to bias the substrate of that power transistor.
Figure 4 illustrates an environment in which the circuit of any of Figures 3A through 3C is used to generate a dynamically changing bias voltage V_{B} which is then applied to the substrate of the power transistor.
Figure 5 illustrates an example inverter circuit that may be used to implement the inverter circuit of Figure 4.
Figure 6 illustrates a cross-sectional view of each of a transistor, a resistor, and a capacitor, each formed on the same silicon substrate that the power transistor is formed on.
Figure 7 illustrates a package that includes an integrated circuit in which the power transistor and all of the biasing circuit are formed monolithically (with the exception of a capacitor).
Figure 8 shows a graph that illustrates an effect of biasing a semiconductor substrate on a leakage current through the semiconductor substrate of a transistor structure such as the transistor structure of Figure 1.
Figure 9 shows a graph that illustrates an effect that biasing a semiconductor substrate has on a current of a transistor structure when the transistor structure runs continuously in both linear and saturation mode.
Figure 10 illustrates a package structure in which a die that has a monolithic implementation of substrate biasing may be packaged.
Figure 11 illustrates another package structure in which the die may be packaged.
Figure 12 illustrates yet another package structure in which the die may be packaged.

### DETAILED DESCRIPTION

Embodiments described herein relate to a transistor structure that includes a biased substrate. For example, a transistor structure comprises a barrier semiconductor layer and a channel semiconductor layer immediately beneath the barrier semiconductor layer to form a heterojunction interface with the barrier semiconductor layer, the heterojunction inducing a two-dimensional electron gas (2DEG) within the channel semiconductor layer. A source contact and a drain contact are each in conductive contact with the 2DEG. A gate terminal is proximate to the 2DEG such that voltages applied to the gate terminal control whether the 2DEG is continuous between the source contact and the drain contact.

A semiconductor substrate is beneath and rigidly coupled to the channel semiconductor layer and the barrier semiconductor layer. For example, the channel layer and barrier semiconductor layer may be epitaxially grown on layers supported by the semiconductor substrate. A substrate contact layer is disposed immediately beneath the semiconductor substrate. The substrate contact layer is electrically disconnected or disconnectable from the source contact to allow for a different voltage to be applied to the substrate contact layer as compared to the source contact. The transistor structure also includes a biasing circuit that is configured to bias the substrate contact layer. Thus, the substrate may be biased to a different voltage than the source terminal.

In other words, the transistor structure embodies a four terminal transistor, the terminals being 1) the source contact, 2) the drain contact, 3) the gate terminal, and 4) the substrate. This contrast with a three terminal device that includes just the source contact, the drain contact, and the gate terminal. In the previous transistor structure, the substrate was shorted to the source contact, and thus the substrate cannot be considered another terminal. Using the substrate as a fourth terminal provides for numerous potential advantages.

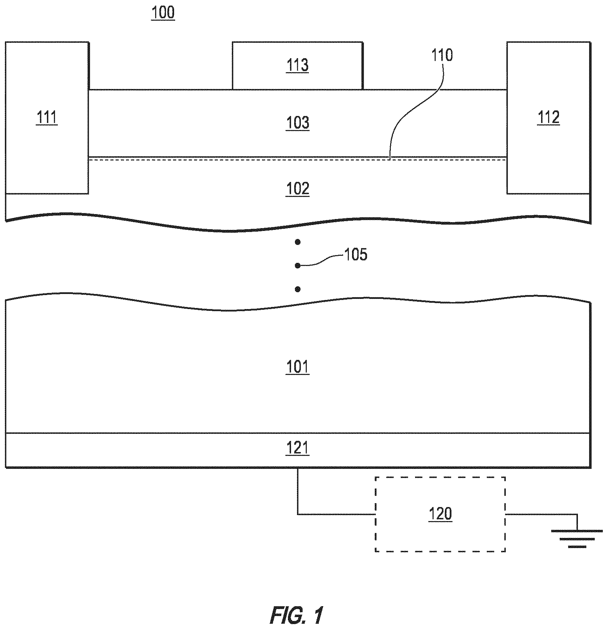

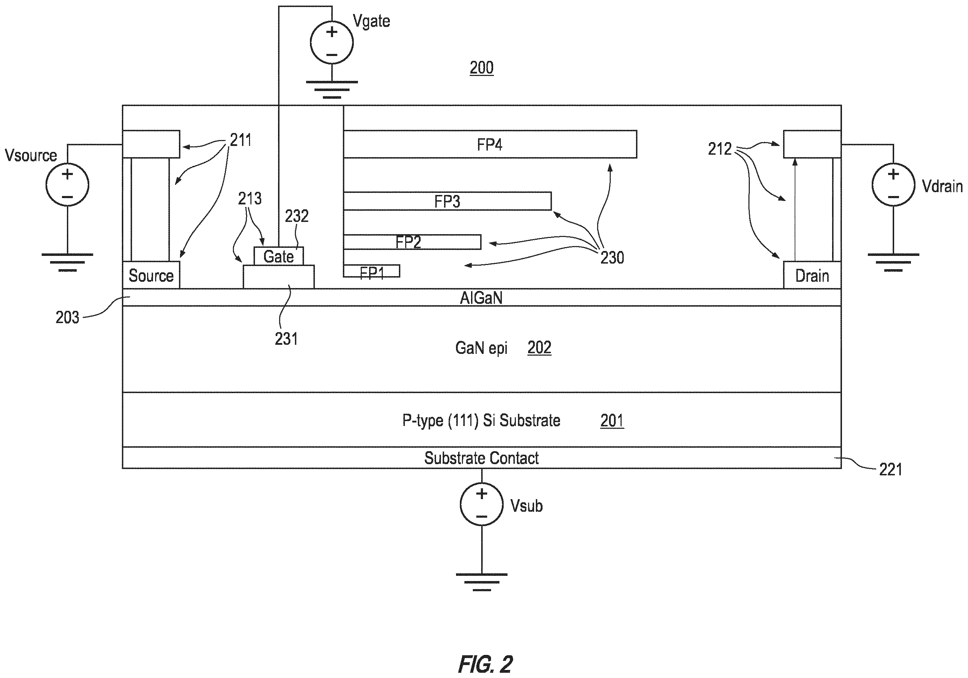

Figure 1 is an illustration of an embodiment of a transistor structure 100 in accordance with the principles described herein. The transistor structure 100 is a simplified diagram used to describe the general principle of substrate biasing. A more specific example will be provided with respect to Figure 2.

The transistor structure 100 may be formed by epitaxially growing an epitaxial stack on a substrate. In this description and in the claims, a direction of growth of this epitaxial stack will be referred to as a "vertical" direction. Consequently, terms describing relative vertical position (such as "beneath", "below", and "above" and so forth) are with respect to this vertical direction. For instance, if a second layer is epitaxially grown on the first layer, the second layer will be "above" the first layer, and the first layer will be "beneath" the second layer.

Returning to Figure 1, the transistor structure 100 includes a semiconductor substrate 101 that forms a foundation on which further layers may be epitaxially grown to formulate part of a transistor structure. The semiconductor substrate 101 may be any semiconductor, including silicon. Layers epitaxially grown on top of the semiconductor substrate 101 will be referred to hereinafter as an "epitaxial stack".

The epitaxial stack includes a channel semiconductor layer 102 epitaxially grown using the semiconductor substrate 101 as a foundation. The channel semiconductor layer 102 may be comprised of any suitable semiconductor, including Gallium Nitride (GaN). The ellipsis 105 represents that there may be any number of layers in the epitaxial stack between the semiconductor substrate 101 and the channel semiconductor layer 102. As an example only, strain relief layers may be formed between the semiconductor substrate and the channel semiconductor layer 102 to thereby improve the mechanical stability and electrical performance of the transistor structure 100. Nevertheless, the principles described herein are not limited to what (if any) layers are between the semiconductor substrate 101 and the channel semiconductor layer 102. Suffice it to say that the semiconductor substrate 101 is rigidly coupled to the channel semiconductor layer 102 to provide adequate support for the channel semiconductor layer 102 as well as the remainder of the epitaxial stack, in the sense that all epitaxial layers are coupled to a substrate on which they are grown.

A barrier semiconductor layer 103 is epitaxially grown on the channel semiconductor layer 102 such that the barrier semiconductor layer 103 is immediately above the channel semiconductor layer 102. A heterojunction interface is present between the channel semiconductor layer 102 and the barrier semiconductor layer 103. The barrier semiconductor layer 103 may be comprised of any suitable semiconductor such as Aluminum Gallium Nitride (AlGaN). The differences in the bandgap profiles of the channel semiconductor layer 102 (e.g., GaN) and the barrier semiconductor layer 103 (e.g., AlGaN) are such that the conduction band edge of the channel semiconductor is pulled downwards near the heterojunction interface, thus creating an energy potential well that dips below the Fermi level vertically just within the channel semiconductor layer 102. Because the well is below the Fermi level, free electrons exist in this well, forming a highly conductive two-dimensional electron gas ("2DEG") 110.

The vertical thickness of the region in which such free electrons exist correspond to the short vertical span of the well that dips below the Fermi level. Thus, the 2DEG is vertically thin. However, the region is planar in the horizontal plane. Thus, this region is called a "Two-Dimensional" Electron Gas to emphasize its planar form. The reference to "Electron Gas" in the term is to emphasize that the electrons in the 2DEG have high mobility. The 2DEG is also referred to as a "sea of electrons" also emphasizing the mobility of the electrons in the 2DEG. The 2DEG may form the channel region of a power semiconductor to allow passage of high currents with relatively low resistance. Thus, 2DEGs are indispensable in high-frequency and high-power electronics, with applications in devices such as high-electron-mobility transistors (HEMTs).

A source contact 111 is in conductive contact with the 2DEG 110, which means that electrons may flow freely between the source contact 111 and the 2DEG 110 (see leftmost portion of the 2DEG 110 as shown in Figure 1). This may be because source contact 111 and the 2DEG 110 are in direct contact (as shown in Figure 1), or perhaps they are not in direct contact, but close enough that the electrons may still flow between the source contact 111 and the 2DEG 110. Likewise, the drain contact 112 is also in conductive contact with the 2DEG 110 (see rightmost portion of the 2DEG 110 as shown in Figure 1). If the 2DEG 110 is continuous between the source contact 111 and the drain contact 112, the 2DEG 110 serves as a channel through which electrons may flow between the source contact 111 and the drain contact 112.

A gate terminal 113 is proximate the 2DEG 110 such that voltages applied to the gate terminal 113 (or more specifically the electrical fields caused by those voltages) control whether the 2DEG 110 is continuous between the source contact 111 and the drain contact 112. When the gate terminal 113 is off, the 2DEG 110 is discontinuous underneath the gate terminal 113, and when the gate terminal 113 is on, then the 2DEG 110 is continuous underneath the gate terminal 113. If the transistor structure 100 is an enhancement mode transistor, the transistor structure 100 is off when no voltage is applied to the gate terminal 113, and on when a sufficient positive voltage is applied to the gate terminal 113. If the transistor structure 100 is a depletion mode transistor, the transistor structure 100 is on when no voltage is applied to the gate terminal 113 and off when a sufficient negative voltage is applied to the gate terminal 113.

Thus, by controlling the continuity of the 2DEG 110 between the source contact 111 and the drain contact 112, voltages applied to the gate terminal 113 control whether the transistor represented by the transistor structure 100 is on or off. In this description, all transistors that use a 2DEG to pass current will be referred to as a "high-electron-mobility transistor" or "HEMT". Thus, Figure 1 illustrates a transistor structure 100 that embodies a HEMT. Conventional HEMTs are three terminal devices, the three terminals being the source contact, the drain contact, and the gate terminal.

In accordance with the principles described herein, a four terminal HEMT is described. That is, the semiconductor substrate 101 is a fourth terminal that is disconnected or at least disconnectable from the source contact 111. That is to say, the voltage (referred to herein as a "bias voltage" or a "bias") that is applied to the semiconductor substrate 101 may be different than the voltage that is applied to the source contact 111. For this purpose, a substrate contact 121 is beneath the substrate 101 and may be electrically disconnected from the source contact 111. This will allow a biasing circuit 120 to apply a bias via the substrate contact 121 to the semiconductor substrate 101 that is independent from the voltage present at the source contact 111. Electrically disconnecting the substrate contact 121 from the source contact 111 allows for the benefits described herein that are associated with biasing the semiconductor substrate 101.

For example, by biasing the substrate 101, the vertical electrical field encountered by the transistor structure 100 may be adjusted. As an example, by weakening the vertical electrical field, the motive power driving vertical leakage is reduced, thus reducing vertical leakage itself, which prevents harm to the transistor structure 100, conserves power, and extends the life of the transistor structure 100. Alternatively, or in addition, the reduced vertical electrical field allows the thickness of the transistor structure to be reduced.

Alternatively, the bias voltage may be adjusted to account for higher drain voltages. Such higher drain voltages would typically mean that the vertical electrical field would increase proportionally to the increase in the drain voltage. However, by controlling the bias voltage to be higher to account for the higher drain voltages, the magnitude of the vertical electrical field may be controlled such that the transistor structure 100 may be a higher voltage device. Even the same transistor structure 100 may be used different voltage applications by appropriately controlling the substrate bias voltage. For instance, if the transistor structure 100 could handle a drain voltage of 400 volts if a substrate bias voltage of 200 volts is applied, the same transistor structure 100 might handle a drain voltage of 1000 volts if a substrate bias voltage of 800 volts is applied.

Furthermore, controlling the substrate bias allows for controlling the charge of the 2DEG 110. For example, by increasing the 2DEG charge, the saturation current of the transistor structure may be increased, allowing more power to be transferred. Alternatively, or in addition, this improved saturation current may allow the transistor to be smaller in footprint. A reduced transistor footprint means that more transistors can be fabricated on a single wafer. Furthermore, since the area of the transistor is reduced, the opportunity for manufacturing defects is reduced, and yield may potentially be increased. That is, there is the potential to reduce the percentage of unusable or defective transistors present on a wafer.

In addition, controlling the substrate bias improves the static and dynamic on-resistance of the transistor. Finally, the electrical decoupling of the source contact 111 from the substrate 101 may allow for more uses of the transistor structure 100 that might otherwise be prohibited by the source contact 111 and the substrate 101 being electrically connected.

For purposes of biasing the substrate 101, a biasing circuit 120 is in conductive contact with a substrate contact 121 and is configured to apply a bias voltage to the semiconductor substrate 101. The biasing circuit 120 may be configured to apply either a fixed or a variable bias to the substrate, and the bias may be positive relative to the source contact 111. The biasing circuit 120 may also be configured to selectively apply a bias voltage to the semiconductor substrate 101 depending on a state of the transistor structure 100.

The biasing circuit 120 may include any number of circuits that are configured to apply a bias to the semiconductor substrate 101. The biasing circuit 120 may be epitaxially grown using the same epitaxial stack that was used to form the barrier semiconductor layer 103 and the channel semiconductor layer 102. Such a configuration may be referred to as a monolithic implementation of substrate biasing. Alternatively, the biasing circuit 120 may be separate and distinct from the epitaxial stack. Such a configuration may be referred to as a co-packaged implementation of a biasing circuit, as the biasing circuit in that embodiment is co-packaged with the epitaxial stack in order to allow for biasing of the semiconductor substrate 101.

Figure 2 illustrates a transistor structure 200 that is a specific example of the transistor structure 100 of Figure 1. The P-type (111) substrate 201 is an example of the substrate 101 of Figure 1, the GaN epitaxial layer 202 is an example of the channel layer 102 of Figure 1, and the AlGaN layer 203 is an example of the barrier layer 103 of Figure 1. Moreover, the source contact structure 211 (having a voltage Vsource applied thereto) is an example of the source contact 111 of Figure 1, the drain contact structure 212 (having a voltage Vdrain applied thereto) is an example of the drain contact 112 of Figure 1, the gate structure 213 (having a voltage Vgate applied thereto) is an example of the gate terminal 113 of Figure 1, and the substrate contact 221 (having a voltage Vsub applied thereto) is an example of the substrate contact 121 of Figure 1. The gate structure 223 includes a p-doped GaN layer 231 which causes the 2DEG to be discontinuous under the gate when there is no voltage applied to a conductive gate 232, thus causing the transistor structure 200 to be an enhancement mode transistor. Thus, as represented by voltages Vsource, Vdrain, Vgate, and Vsub, four different voltages may be applied to four different terminals of the transistor structure 200. Accordingly, the transistor structure 200 is a four terminal HEMT. A field plate structure 230 is also shown (which includes field plates FP1, FP2, FP3 and FP4) , which allows for management of the electrical field profile in the 2DEG.

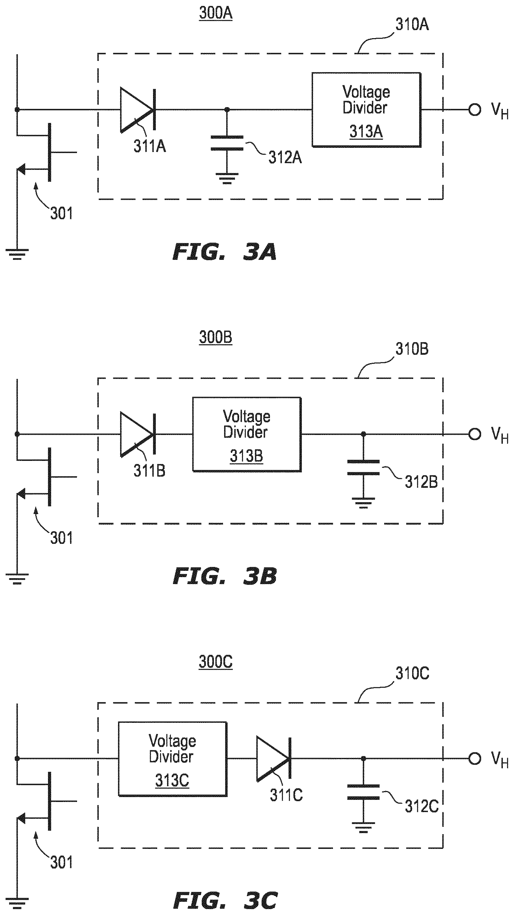

Figures 3A, 3B and 3C each illustrate biasing environments 300A, 300B, and 300C (respectively) in which a high voltage V_{H} is generated from a drain of a power transistor 301, where that high voltage V_{H} may then be used to bias the substrate of that power transistor 301. The power transistor 301 is an example of the transistor formed by the transistor structure 100 of Figure 1 or the transistor structure 200 of Figure 2.

For instance, the biasing environment 300A of Figure 3A includes a circuit 310A that uses the drain of a power transistor 301 to generate a high voltage V_{H}, the biasing environment 300B of Figure 3B includes a circuit 310B that uses the drain of a power transistor 301 to generate a high voltage V_{H}, and the biasing environment 300C of Figure 3C includes a circuit 310C that uses the drain of a power transistor 301 to generate a high voltage V_{H}. Thus, in each case, the high voltage V_{H} is generated from the drain of a power transistor 301.

As an example, the high voltage V_{H} may be some fraction (e.g., one half) of the drain voltage present at the drain terminal of the power transistor 301 when the power transistor 301 is off. To illustrate, if the off drain voltage is 400 volts, the high voltage V_{H} may be a fraction of the drain voltage (e.g., 200 volts). While this may be any fraction, the high voltage V_{H} is preferably at least ten percent of the off drain voltage of the power transistor 301. For instance, if the off drain voltage is 400 volts, it is preferred that the high voltage V_{H} be at least 40 volts.

The circuits 310A, 310B and 310C may be referred to collectively as "circuits 310", or where any of the circuits 310 will suffice, the circuit may be referred to simply as the "circuit 310". Any of the circuits 310 may be used to generate the high voltage V_{H} from the drain voltage of the power transistor 301. Each circuit 310 includes a rectifier, a ground-connected capacitor, and a voltage divider connected in series from the drain of the power transistor 301 to the output that provides the high voltage V_{H}.

For instance, the circuit 310A includes a rectifier 311A, then a ground-connected capacitor 312A, and then a voltage divider 313A connected in that order in series from the drain of the power transistor 301 to the output that provides the high voltage V_{H}. However, to emphasize that the placement of the voltage divider is flexible, the circuit 310B includes first a rectifier 311B, and then a voltage divider 313B, and then a ground connected capacitor 312B in the series. Furthermore, the circuit 310C includes first a voltage divider 313C, followed by a rectifier 311C and then a ground-connected capacitor 312C.

The rectifiers 311A, 311B and 311C (referred to collectively as "rectifiers 311") may be any circuit element that outputs a rectified form of its input voltage. As an example, the rectifiers 311 may each be a diode. The voltage dividers 313A, 313B and 313C (referred to collectively as "voltage dividers 313") could be, for example, resistors connected in series between the input of the voltage divider and ground, where the output of the voltage divider is one of the intermediate nodes between the resistors. Alternatively, the voltage dividers 313A, 313B and 313C could be, for example, capacitors connected in series between the input of the voltage divider and ground, where the output of the voltage divider is one of the intermediate nodes between the capacitors.

When the power transistor 301 is off, the drain voltage of the power transistor 301 is high, allowing charge to flow (from left to right in Figures 3A through 3C) through the rectifiers 311A, 311B and 311C. In the case of the rectifier 311A, the charge is provided directly to the upper terminal of the capacitor 312A replenishing the charge on the capacitor 312A and thereby stabilizing the voltage across the capacitor 312A at a high level. That high voltage is then provided to a voltage divider 313A which then outputs another high voltage V_{H} that is some fraction of the voltage across the capacitor 312A. In the case of the rectifier 311B, the charge is indirectly provided to the upper terminal of the capacitor 312B via a voltage divider 313B to thereby replenish the charge on the capacitor 312B to be at the high voltage V_{H}. In the case of the rectifier 311C, the rectifier 311C receives the charge from the drain of the power transistor 301 indirectly via the voltage divider 313C, and transfers that charge to charge the capacitor 312C to be at the high voltage V_{H}.

When the power transistor 301 is on, the drain voltage of the power transistor 301 is relatively low, and thus the rectifiers 311 are each reverse-biased, thereby allowing the capacitors 312A, 312B and 312C (referred to collectively as the "capacitors 312") to keep their charge. Charge is drawn at a low rate by using the high voltage V_{H} to bias the substrate contact of the transistor structure (e.g. to bias the substrate contact 121 of the transistor structure 100 of Figure 1, or to bias the substrate contact 221 of the transistor structure 200 of Figure 2). However, the capacitors 312 are each sized to be large enough that the capacitors still substantially maintain their voltage despite some small current drawn to bias the substrate.

In one embodiment, the high voltage V_{H} is applied directly to the substrate contact (e.g., the substrate contact 121 of Figure 1, or the substrate contact 221 of Figure 2). In that case, the bias voltage applied to the substrate is a relatively constant positive bias voltage provided that the capacitor of the circuit 300 is large enough. This is because the amount of current drawn from the circuit 300 is not large since the current is drawn only to charge the substrate contact to sufficient voltage. Thus, the circuit 300 generates a high voltage V_{H} but uses only modest amount of current to do so. When providing the high voltage V_{H} directly to the substrate, it may be advantageous to provide some level of carbon doping in the epitaxial stack, and in particular in the GaN channel layer, and the AlGaN barrier layer. This might reduce leakage when the transistor is off, but yet the substrate bias is still being applied.

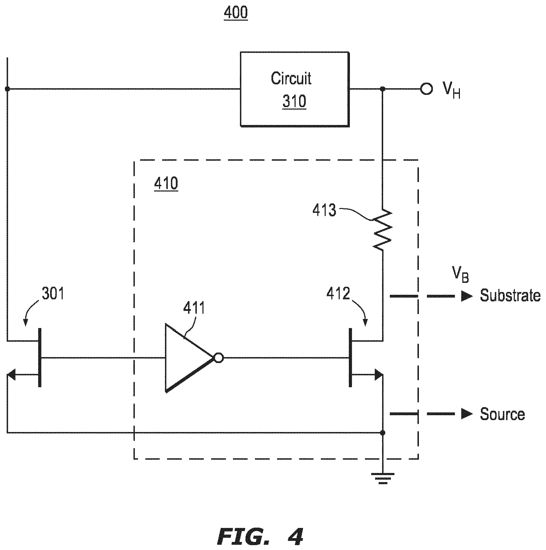

In another embodiment, the high voltage V_{H} is used to apply a dynamic voltage to the substrate. For instance, the positive bias voltage may be selectively applied depending on a state of the transistor structure (e.g., whether the transistor is on or off), or the bias may change depending on a state of the transistor structure. Figure 4 illustrates an environment 400 in which the circuit 310 of any of Figures 3A through 3C is used to apply generate a dynamically changing bias voltage V_{B} which is then applied to the substrate of the power transistor 301.

For example, the environment 400 includes the power transistor 301, the circuit 310 and a biasing circuit 410. As previously explained, the circuit 310 generates a high voltage V_{H} from the power applied to the drain of the power transistor 301. The combination of the circuit 310 and the biasing circuit 410 is an example of the biasing circuit 120 of Figure 1. In the specific example of Figure 4, the biasing circuit 410 includes an inverter circuit 411, a transistor 412, and a resistor 413.

As an example, the inverter circuit 411 may be an inverter. In any case, the inverter circuit 411 outputs a high signal when its input is low, and outputs a low signal when its input is high. The inverter circuit 411 has an input terminal connected to the gate terminal of the power transistor 301, and an output terminal connected to a gate terminal of the transistor 412. Thus, if a high signal is applied to the gate terminal of the power transistor 301, a low signal is applied to the gate terminal of the transistor 412, and vice versa.

As previously mentioned, when a high signal is applied to the gate terminal of the power transistor 301, a low signal is applied to the gate terminal of the other transistor 412, which causes the transistor 412 to be off. Accordingly, even though resister 413 is present between the drain terminal of the transistor 412 and the high voltage V_{H}, there is little or no current passing through the resistor 413, and thus the drain terminal of the transistor 412 still substantially assumes the high voltage V_{H}. Therefore, when the power transistor 301 is on, a high voltage V_{H} is applied to as the bias voltage V_{B} to bias the substrate of the power transistor 301. For instance, in Figure 1, the biasing circuit 120 would bias the substrate 101 with a bias voltage when the 2DEG 110 is conducting current from the drain contact 112 to the source contact 111. In this description, an example will be frequently referred to in which the bias voltage is 200 volts. However, the bias voltage may also be any voltage that is at least 40 volts. That said, any positive bias will reduce vertical leakage. Thus, the principles described herein are not limited to the precise values of the bias voltage.

On the other hand, referring again to Figure 4, when a low signal is applied to the gate terminal of the power transistor 301, a high signal is applied to the gate terminal of the other transistor 412, which causes the transistor 412 to be on. In this state, because the resistor 413 has a high resistance compared to the on-resistance of the transistor 412, the voltage at the drain terminal of the transistor 412 goes quite low (perhaps on the order of a few volts). Thus, when the power transistor 301 is off, negligible bias voltage is applied to the substrate of the power transistor 301. For instance, in Figure 1, the bias voltage V_{B} is negligible and thus biasing circuit 120 would bias the substrate 101 with no or negligible bias voltage (e.g., a few volts) when the 2DEG 110 is not conducting current from the drain contact 112 to the source contact 111. In at least such a way, the biasing circuit 410 selectively applies a positive bias voltage depending on a state of the power transistor 401. Thus, the biasing voltage can change to adapt the power transistor to reduce leakage current.

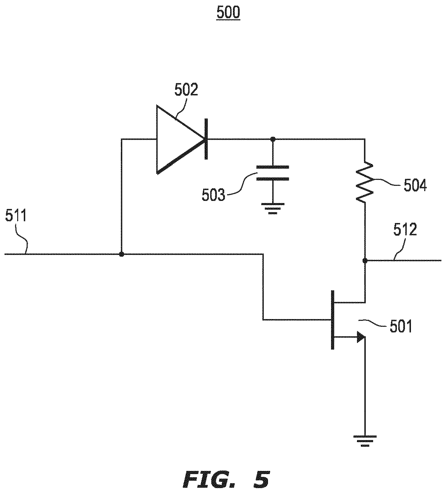

Figure 5 illustrates an example inverter circuit 500 that may be used to implement the inverter circuit 411 of Figure 4. Of course, there are many ways to implement an inverter, so this is just an example. The inverter circuit 500 includes a transistor 501, a diode 502, a capacitor 503, and a resistor 504. The input 511 of the inverter circuit 500 is connected to the gate of the power transistor 301 (as shown in Figure 4). Accordingly, the on-off pulse that drives the gate of the power transistor 301 is also applied to the input 511 of the inverter circuit 500. Due to the diode 502, the capacitor 503 is charged to be close to the on voltage applied to the gate of the power transistor 301. Thus, the capacitor 503 may be charged to be about 5 volts.

When a high voltage is applied to the gate of the power transistor 301 (and to the input 511 of the inverter circuit 500), a high voltage is also applied to the gate of the transistor 501, turning the transistor 501 on. Due to the resistor 504 dominating over the on-resistance of the transistor 501, the output 512 of the inverter circuit 500 is low. Thus, when there is a high voltage (e.g., 5 or 6 volts) applied to the input 511 of the inverter circuit 500, the inverter circuit applies a low voltage (e.g., substantially ground) to the output 512 of the inverter circuit.

On the other hand, when a low voltage is applied to the gate of the power transistor 301 (and to the input 511 of the inverter circuit 500), a low voltage is also applied to the gate of the transistor 501, turning the transistor 501 off. Since little or no current would then pass through the resistor 504, the output 512 of the inverter circuit 500 would then assume close to the same voltage that is stored across the capacitor 503, which is a relatively high 5 or 6 volts. Thus, when the input 511 of the inverter circuit 500 is low, the output 512 of the inverter circuit 500 is high.

The precise design of the inverter circuit 500 is not important. What is emphasized about the inverter circuit 500 is that it contains only four types of elements, 1) a transistor, 2) a resistor, 3) a capacitor, and 4) a diode. Furthermore, in Figure 4 other than the inverter circuit 411 (of which the inverter circuit 500 is an example), the bias circuit 410 is also only composed of elements selected from these four types of elements. Also, in Figures 3A through 3C, any of the circuits 310 are also composed of elements selected from these four types of elements (recalling that the voltage dividers 313 may be composed of a series connection of resistors, or a series connection of capacitors). Thus, the biasing circuit 120 of Figure 1 may be composed of four types of elements including 1) a transistor, 2) a resistor, 3) a capacitor, and 4) a diode.

However, a diode can be constructed using a transistor by connecting the gate and source of the transistor. Accordingly, the biasing circuit 120 of Figure 1 may be composed of as few as three types of elements including 1) a transistor, 2) a resistor, and 3) a capacitor. Finally, a capacitor may be implemented using a high voltage transistor connected in diode-configuration (with its gate and source being connected), and in which the drain-to-source parasitic capacitance is used as the capacitor. In this case, the biasing circuit 120 of Figure 1 may be composed of as few as two elements including 1) transistors, and 2) resistors.

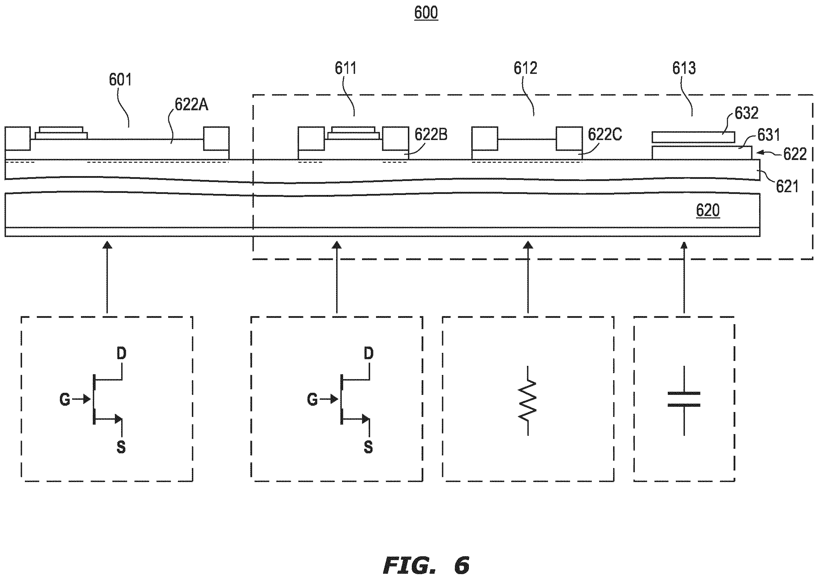

Figure 6 illustrates a cross-sectional view 600 of each of a transistor 611, a resistor 612, and a capacitor 613, each formed on the same silicon substrate 620 that the power transistor 601 is formed on. Furthermore, the power transistor 601, the transistor 611 and the resistor 612 are each formed of portions of the same epitaxial stack. Specifically, the power transistor 601, the transistor 611 and the resistor 612 are each structured using a common channel layer 621. Furthermore, the power transistor 601 includes a portion 622A of a barrier semiconductor layer 622, the transistor 611 includes another portion 622B of the barrier semiconductor layer 622, and the resistor 612 includes another portion 622C of the barrier semiconductor layer 622.

The power transistor 601 takes substantially the same form as the transistor structure 200 of Figure 2. A 2DEG is represented by a horizontal dashed line, which is discontinuous under the gate of the power transistor 601, but which can be controlled to be selectively continuous by application of voltages to the gate of the power transistor 601. Similarly, the transistor 611 (which is a low voltage transistor) also uses a 2DEG that is formed from the same heterojunction, where again the continuity of the 2DEG under the gate may be controlled by application of appropriate voltages to the gate. The resistor 612 takes a similar form as the transistors 601 and 602, except with no gate structure at all, and thus the 2DEG is always continuous between the two terminals of the resistor. The capacitor 613 may be formed using two metal layers 631 and 632 separated by an insulator layer. Alternatively, a capacitor may be implemented using a high voltage transistor that has a lower channel width perpendicular to current flow than the power transistor 601.

Thus, by forming instances of the transistor 611 and the resistor 612 in the same epitaxial stack as the power transistor 611, and forming the capacitor 613 using metal-insulator-metal (MIM) technology as shown (or composing a capacitor out of the drain-to-source parasitic capacitance of a high voltage transistor), and by forming appropriate connections as for example illustrated in Figures 3A through 3C and Figures 4 and 5, the bias circuit 120 may be formed monolithically with the transistor structure 100.

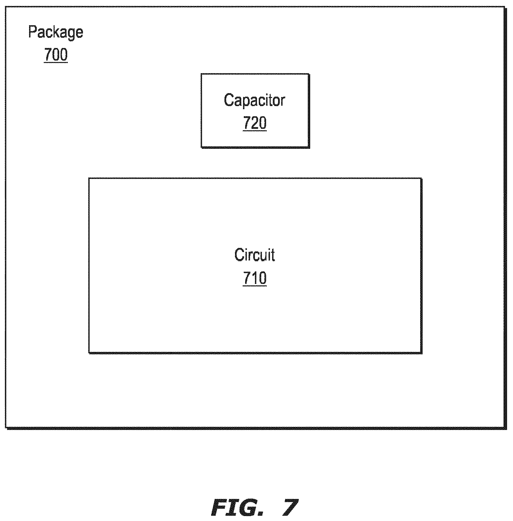

In one embodiment, one or more of the capacitors may be formed off-chip, but still may be packaged within the same package as the other components of the biasing circuit and power transistor. For instance, Figure 7 illustrates a package 700 that includes an integrated circuit 710 (i.e., a chip) in which the power transistor and all of the biasing circuit are formed monolithically (with the exception of a capacitor). In Figure 7, the capacitor 720 is a discrete component that is located off-chip, but which is co-packaged with the integrate circuit. Alternatively, even the capacitor may be formed monolithically with the power transistor and the remainder of the biasing circuitry.

The monolithic construction of the bias circuit with the power transistor allows for a streamlined manufacturing process for implementations of substrate biasing. Because the elements used in implementations of the biasing circuit 120 may be relatively small compared to the power transistor, the footprint of implementations of the biasing circuit 120 may be small in comparison to the power transistor 301. Thus, the implementations of the biasing circuit 310 may only marginally (if at all) impact a die area in a monolithic implementation of embodiments described herein. Die area plays a crucial role in determining manufacturing cost, as it directly influences the number of chips that can be produced on a single wafer. Generally, smaller die sizes allow for higher chip yields per wafer, resulting in lower production costs per unit. In some implementations, the monolithic implementation of substrate biasing may have only a very low die penalty.

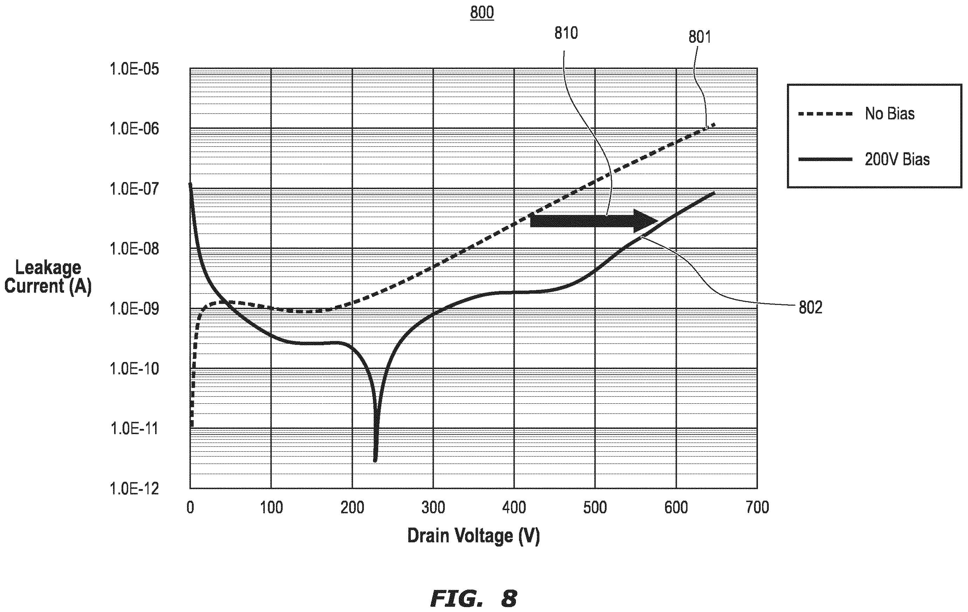

Figure 8 shows a graph 800 that illustrates an effect of biasing a semiconductor substrate on a leakage current through the semiconductor substrate of a transistor structure such as the transistor structure 100 of Figure 1. In the graph 800, line 801 shows the absolute value of the leakage current for varying drain voltage levels without any semiconductor substrate biasing. Line 802 shows the absolute value of the leakage current for varying drain voltage levels with a 200-volt semiconductor substrate bias. In both circumstances, the voltage between the gate and the source was zero. As shown by Figure 8 by arrow 810, the leakage current is shifted roughly by the amount of the bias. In other words, for a given drain voltage, the transistor structure 100 experiences less leakage current with a semiconductor substrate bias as opposed to without a semiconductor substrate bias. Stated differently, the same amount leakage current may be encountered for different drain voltages by adjusting the substrate bias voltage.

The reduction in leakage current as shown in Figure 8 may allow for improved yields of the manufacturing process, for example, by enabling a thinner GaN layer. The transistor structure 100 of Figure 1 may include epitaxially growing a GaN layer on a Silicon layer, which may be cost effective. As an example, the GaN layer may be similar to the channel semiconductor layer 102 of Figure 1. The epitaxial growth of the GaN layer may be limited by the strength of the supporting layer of Silicon. If the GaN layer is too thick, the Silicon layer may not be strong enough to provide support for the GaN layer. The GaN layer may thus become deformed and therefore inoperable as a transistor structure. The reduction in leakage current as shown in Figure 8 may enable a thinner GaN layer due to the substrate biasing. Manufacturing defects arising from a GaN layer that is too thick may thus decrease, enabling an increased yield in the manufacturing process. Thus, the transistor structure 100 may enable greater yields of the manufacturing process by enabling a thinner GaN layer.

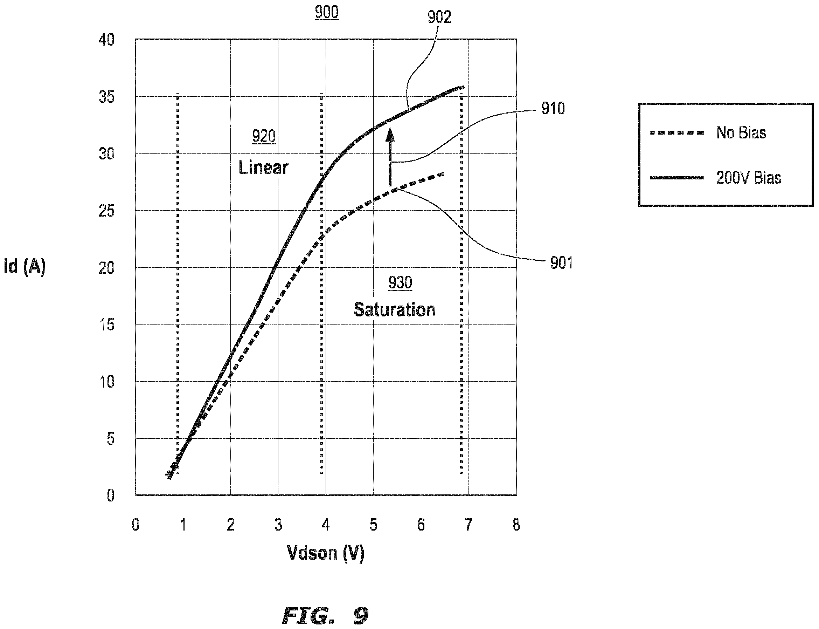

Figure 9 shows a graph 900 that illustrates an effect that biasing a semiconductor substrate has on a current of a transistor structure when the transistor structure runs continuously in both linear and saturation mode. Such a transistor structure could be, for instance, the transistor structure 100 of Figure 1. A common use of the transistor structure 100 can be a continuous use, which may include running the transistor structure 100 for a long time. For example, the transistor structure 100 may be run for hours, days, or weeks straight. The transistor structure 100 may be running when current is flowing between the source contact 111 and the drain contact 112. Additionally, the transistor structure 100 may be considered to be running in the linear mode (e.g., region 920 of Figure 9) when the outputted current increases linearly with the voltage applied. The transistor structure 100 may be considered to be running in the saturation mode (e.g., region 930 of Figure 9) when the outputted current increases much less, if at all, with increases with the voltage applied. In this mode, the outputted current may also be called the saturation current of the transistor structure 100.

Saturation current may be an important characteristic of a transistor. The higher the saturation current of the transistor, the more power the transistor may deliver when operating in saturation mode. Additionally, the higher the saturation current, the more efficient the transistor may be at delivering that power, as more current is being driven at a given voltage. It may thus be desirable to achieve higher saturation currents for any given transistor, as doing so may increase both the efficiency of the transistor in delivering power and the capability of the transistor to deliver power.

Returning to Figure 9, Figure 9 includes a graph 900 with lines 901 and 902. Line 901 shows the current over varying voltages where the semiconductor substrate 101 of the transistor structure 100 is not biased and is instead held at the same voltage as the source contact. Line 902 shows the current over a varying voltage where the semiconductor substrate 101 is biased to 200V. As shown by arrow 910, biasing the semiconductor substrate 101 yields significant improvement in the saturation current when the transistor structure 100 is running continuously and in the saturation region. Furthermore, as shown in the slope in linear region of the I-V curve, substrate biasing leads to an improvement in the on-resistance of the transistor.

As shown in Figure 9, embodiments herein described may enable a higher saturation current when the semiconductor substrate is biased versus when the semiconductor substrate is not biased. This means that for a given voltage, semiconductor substrate biasing may enable a transistor structure to push more current than a transistor structure can without semiconductor substrate biasing. Thus, embodiments described herein may enable higher saturation currents, increasing both the efficiency of the transistor structure 100 in delivering power and the capability of the transistor structure 100 to deliver power.

Thus, a transistor structure such as transistor structure 100 of Figure 1 may enable a number of benefits including a higher saturation current, a reduced transistor structure footprint, and a higher yield of the manufacturing process.

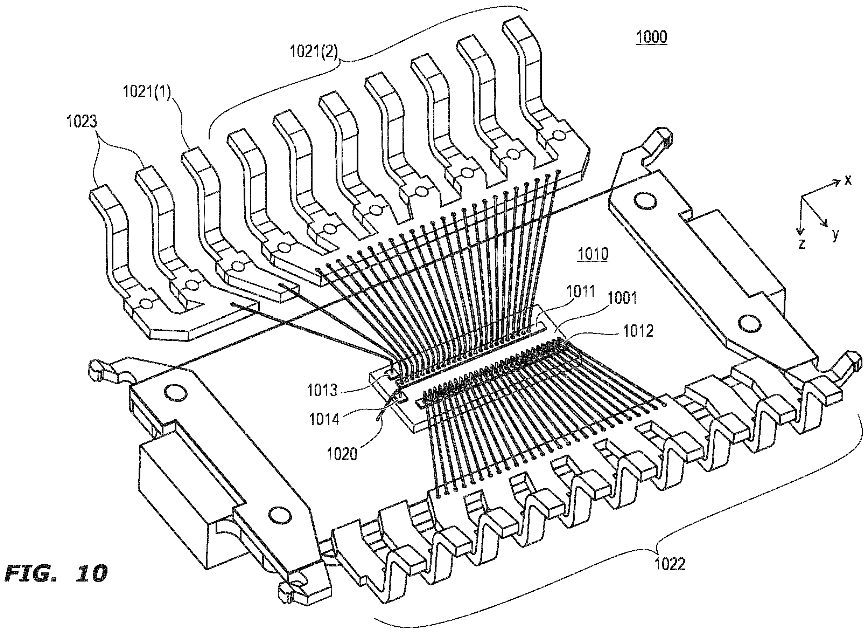

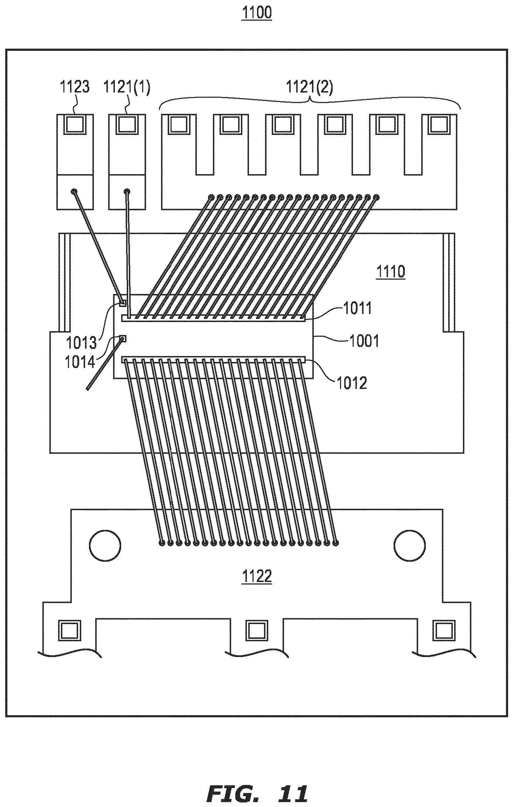

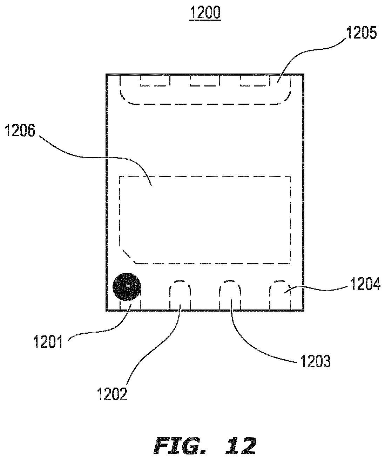

Now several packaging structures and techniques will be described when the substrate biasing is monolithic (on the same die) as the power transistor. Figure 10 illustrates a PSOP package 1000, Figure 11 illustrates a TOLL package 1100, and Figure 12 illustrates a PQFN package 1200. In each case, the package includes a die 1001 in which a power transistor and the biasing circuit are both implemented (though the die is not illustrated in Figure 12).

Figure 10 illustrates a PSOP package 1000 that includes the die 1001. The die 1001 is mounted on a conductive base 1010 that represents a part of the lead frame of the PSOP package 1000. The die 1001 includes a source contact 1011 that is wire bonded to a source sense terminal 1021(1) of the lead frame, and that is wire bonded to a source terminal 1021(2) of the lead frame. The die 1001 also includes a drain contact 1012 that is wire bonded to a drain terminal 1022 of the lead frame. The die 1001 further includes a gate contact 1013 that is wire bonded to a gate terminal 1123of the lead frame.

The die 1001 also includes a substrate bias contact 1014 on which the substrate biasing voltage is applied by the biasing circuit that is internal to the die 1001. In Figure 10, substrate biasing is completed by a wire 1020 connecting the substrate bias contact 1014 with the conductive base 1010 that is also conductively connected to the substrate of the die 1001. In an alternative embodiment, the bias substrate is applied to the conductive base 1010 through a conductive via formed within the die 1001 itself.

Figure 11 illustrates a TOLL package in which the die 1001 is packaged. The die 1001 is mounted to a conductive base 1110 of the lead frame of the TOLL package. The source contact 1011 of the die 1001 is wire bonded to a source sense terminal 1121(1) of the lead frame, and is also wire bonded to a source terminal 1121(2) of the lead frame. The drain contact 1012 is wire bonded to a drain terminal 1122 of the lead frame. The gate contact 1013 is wire bonded to a gate terminal 1123 of the lead frame. The substrate bias voltage may be applied to the conductive base 1110 via a wire connected to a substrate bias pad 1014, or instead through a via formed in the die 1001 itself. The TOLL package of Figure 11 has been modified such that the source contact 1121(2) is electrically disconnected from the conductive base 1110, whereas in a conventional Toll package they are integral.

Substrate biasing may also be performed using a PQFN package. Figure 12 illustrates a conventional PQFN package 1200 which may be modified to contain the die 1001. The pins 1201 and 1202 are convention not used. However, in on embodiment, the pins 1201 and 1202 may be used as source pins, the pin 1203 as a gate pin, the pin 1204 as a source sense pin, and pin 1205 as a drain pin, and the plate 1206 as a substrate contact plate.

### Literal Support Section

Clause 1. A transistor structure comprising: a barrier semiconductor layer; a channel semiconductor layer immediately beneath the barrier semiconductor layer to form a heterojunction interface with the barrier semiconductor layer, the heterojunction inducing a two-dimensional electron gas (2DEG) within the channel semiconductor layer; a source contact in conductive contact with the 2DEG; a drain contact in conductive contact with the 2DEG; a gate terminal that is proximate to the 2DEG such that voltages applied to the gate terminal control whether the 2DEG is continuous between the source contact and the drain contact; a semiconductor substrate beneath and rigidly coupled to the channel semiconductor layer and the barrier semiconductor layer; a substrate contact layer disposed immediately beneath the semiconductor substrate, the substrate contact layer being electrically disconnected from the source contact to allow for a different voltage to be applied to the substrate contact layer as compared to the source contact; and a biasing circuit configured to bias the semiconductor substrate.

Clause 2. The transistor structure of clause 1, the semiconductor substrate being a Silicon substrate.

Clause 3. The transistor structure of clause 1, the barrier semiconductor layer being an AlGaN layer, the channel semiconductor layer being a GaN layer.

Clause 4. The transistor structure of clause 1, the drain contract being in conductive contact with the 2DEG by being in direct contact with the 2DEG, and the source contract being in conductive contact with the 2DEG by being in direct contact with the 2DEG.

Clause 5. The transistor structure of clause 1, the biasing circuit being configured to bias the semiconductor substrate by applying a positive bias voltage to the substrate contact layer, the positive bias voltage being positive relative to a source voltage applied to the source terminal.

Clause 6. The transistor structure of clause 5, the positive bias voltage being a fixed positive voltage relative to the source voltage.

Clause 7. The transistor structure of clause 5, the positive bias voltage being selectively applied depending on a state of the transistor structure.

Clause 8. The transistor structure of clause 5, the positive bias voltage changing depending on a state of the transistor structure.

Clause 9. The transistor structure of clause 5, the biasing circuit being configured such that the positive bias voltage has a maximum voltage of more than 40 Volts to the semiconductor substrate.

Clause 10. The transistor structure of clause 1, the biasing circuit comprising: a transistor, a drain of the transistor being connected to the substrate contact layer, a gate of the transistor being coupled to an inverter circuit, a source of the transistor being connected to ground.

Clause 11. The transistor structure of clause 1, the biasing circuit further being configured to bias the semiconductor substrate contact layer, the biasing circuit being connected to the semiconductor substrate contact layer with a wire.

Clause 12. The transistor structure of clause 1, the biasing circuit being in direct contact with the substrate.

Clause 13. The transistor structure of clause 1, the channel semiconductor layer and the barrier semiconductor layer formed by epitaxially deposition of an epitaxial stack on the semiconductor substrate, the channel semiconductor layer and the barrier semiconductor layer being formed of a part of the epitaxial stack, the biasing circuit also being formed of another part of the epitaxial stack.

Clause 14. The transistor structure of clause 1, the channel semiconductor layer and the barrier semiconductor layer formed by epitaxially deposition of an epitaxial stack on the semiconductor substrate, the channel semiconductor layer and the barrier semiconductor layer being formed of a part of the epitaxial stack, the biasing circuit being separate and distinct from the epitaxial stack, the biasing circuit being coupled with the epitaxial stack.Although the subject matter has been described in language specific to structural features and/or methodological acts, it is to be understood that the subject matter defined in the appended claims is not necessarily limited to the described features or acts described above, or the order of the acts described above. Rather, the described features and acts are disclosed as example forms of implementing the claims.

The present disclosure may be embodied in other specific forms without departing from its essential characteristics. The described embodiments are to be considered in all respects only as illustrative and not restrictive. All changes which come within the meaning and range of equivalency of the claims are to be embraced within their scope.

When introducing elements in the appended claims, the articles "a," "an," "the," and "said" are intended to mean there are one or more of the elements. The terms "comprising," "including," and "having" are intended to be inclusive and mean that there may be additional elements other than the listed elements.

## Claims

1. A transistor structure comprising:
a barrier semiconductor layer;
a channel semiconductor layer immediately beneath the barrier semiconductor layer to form a heterojunction interface with the barrier semiconductor layer, the heterojunction inducing a two-dimensional electron gas (2DEG) within the channel semiconductor layer;
a source contact in conductive contact with the 2DEG;
a drain contact in conductive contact with the 2DEG;
a gate terminal that is proximate to the 2DEG such that voltages applied to the gate terminal control whether the 2DEG is continuous between the source contact and the drain contact;
a semiconductor substrate beneath and rigidly coupled to the channel semiconductor layer and the barrier semiconductor layer;
a substrate contact layer disposed immediately beneath the semiconductor substrate, the substrate contact layer being electrically disconnected from the source contact to allow for a different voltage to be applied to the substrate contact layer as compared to the source contact; and
a biasing circuit configured to bias the semiconductor substrate.

2. The transistor structure of claim 1, the semiconductor substrate being a Silicon substrate.

3. The transistor structure of claim 1 or 2, the barrier semiconductor layer being an AlGaN layer, the channel semiconductor layer being a GaN layer.

4. The transistor structure of any one of claims 1 to 3, the drain contract being in conductive contact with the 2DEG by being in direct contact with the 2DEG, and the source contract being in conductive contact with the 2DEG by being in direct contact with the 2DEG.

5. The transistor structure of any one of claims 1 to 4, the biasing circuit being configured to bias the semiconductor substrate by applying a positive bias voltage to the substrate contact layer, the positive bias voltage being positive relative to a source voltage applied to the source terminal.

6. The transistor structure of claim 5, the positive bias voltage being a fixed positive voltage relative to the source voltage.

7. The transistor structure of claim 5, the positive bias voltage changing depending on a state of the transistor structure.

8. The transistor structure of any one of claims 5 to 7, the positive bias voltage being selectively applied depending on a state of the transistor structure.

9. The transistor structure of any one of claims 5 to 8, the biasing circuit being configured such that the positive bias voltage has a maximum voltage of more than 40 Volts to the semiconductor substrate.

10. The transistor structure of any one of claims 1 to 9, the biasing circuit comprising:
a transistor, a drain of the transistor being connected to the substrate contact layer, a gate of the transistor being coupled to an inverter circuit, a source of the transistor being connected to ground.

11. The transistor structure of any one of claims 1 to 10, the biasing circuit further being configured to bias the semiconductor substrate contact layer, the biasing circuit being connected to the semiconductor substrate contact layer with a wire.

12. The transistor structure of any one of claims 1 to 11, the biasing circuit being in direct contact with the substrate.

13. The transistor structure of any one of claims 1 to 12, the channel semiconductor layer and the barrier semiconductor layer formed by epitaxially deposition of an epitaxial stack on the semiconductor substrate, the channel semiconductor layer and the barrier semiconductor layer being formed of a part of the epitaxial stack, the biasing circuit also being formed of another part of the epitaxial stack.

14. The transistor structure of any one of claims 1 to 13, the channel semiconductor layer and the barrier semiconductor layer formed by epitaxially deposition of an epitaxial stack on the semiconductor substrate, the channel semiconductor layer and the barrier semiconductor layer being formed of a part of the epitaxial stack, the biasing circuit being separate and distinct from the epitaxial stack, the biasing circuit being coupled with the epitaxial stack.
